# EUROPEAN PATENT SPECIFICATION

(11) **EP 0 893 474 B1**
(45) Date of publication and mention of the grant of the patent: **18.06.2003**
(21) Application number: 98302984.4
(22) Date of filing: 17.04.1998
(51) Int. Cl.: C08L 63/00, H01B 3/40, H05K 1/03, H05K 3/46

(54) **Epoxy resin composition and a process for manufacturing a multilayer printed-wiring board using it**
Epoxyharzzusammentsetzung und ein Verfahren zur Herstellung einer mehrschichtigen Leiterplatte
Composition de résine epoxy et procédé de préparation d'un circuit imprimé multicouche

(30) Priority: 17.04.1997 JP 10005797; 26.06.1997 JP 17005297
(43) Date of publication of application: 27.01.1999
(73) Proprietor: Ajinomoto Co., Inc., Tokyo (JP)
(72) Inventor: Nakamura, Shigeo, Kawasaki-ku, Kawasaki-shi, Kanagawa-ken (JP); Miyazawa, Yuki, Kawasaki-ku, Kawasaki-shi, Kanagawa-ken (JP); Yokota, Tadahiko, Kawasaki-ku, Kawasaki-shi, Kanagawa-ken (JP)
(74) Representative: Nicholls, Kathryn Margaret

(56) References cited:
- EP-A- 0 742 265
- EP-A- 0 851 726
- PATENT ABSTRACTS OF JAPAN vol. 018, no. 347 (C-1219), 30 June 1994 (1994-06-30) & JP 06 088062 A (NOK CORP), 29 March 1994 (1994-03-29)
- PATENT ABSTRACTS OF JAPAN vol. 1996, no. 07, 31 July 1996 (1996-07-31) & JP 08 067745 A (SUMITOMO BAKELITE CO LTD), 12 March 1996 (1996-03-12)
- PATENT ABSTRACTS OF JAPAN vol. 1997, no. 02, 28 February 1997 (1997-02-28) & JP 08 253557 A (DAINIPPON INK &CHEM INC), 1 October 1996 (1996-10-01)
- PATENT ABSTRACTS OF JAPAN vol. 1997, no. 03, 31 March 1997 (1997-03-31) & JP 08 311142 A (DAINIPPON INK &CHEM INC), 26 November 1996 (1996-11-26)

## Description

This invention relates to an epoxy resin composition suitable for interlayer insulation in a multilayer printed-wiring board of the build-up type. These multilayer boards typically consist- of alternate layers of conductor circuitry and insulating materials. The invention also relates to a process for manufacturing a multilayer printed-wiring board using the epoxy resin composition.

There has been known as a process for manufacturing a multilayer printed-wiring board a process in which copper foils are laminated in a press on an internal-layer circuit board having a circuit formed thereon by using as insulating bonding layers several prepreg sheets each prepared by impregnating glass cloth with an epoxy resin and curing it to a B-stage, and in which interlayer continuity is made by through holes. This process has, however, had problems including a high cost incurred by large-scale equipment and a long time as required for molding under heat and pressure by a laminating press, and the formation of a fine pattern made difficult by an increased copper thickness due to through-hole plating on an external layer. Attention has recently been drawn, as means for solving those problems, to the technique by which organic insulating layers are formed alternately on conductor layers of an internal-layer circuit board for making a multilayer printed-wiring board of the build-up type. Japanese Patent Applications Laid-Open Nos. Hei 7-304931 and Hei 7-304933 disclose a process for manufacturing a multilayer printed-wiring board by coating an internal-layer circuit board having a circuit formed thereon with an epoxy resin composition, curing it under heat, forming an uneven roughened surface thereon with a roughening agent and forming conductor layers by plating. Japanese Patent Application Laid-Open No. Hei 8-64960 makes known a process for manufacturing a multilayer printed-wiring board by applying an undercoat adhesive, drying it preliminarily, bonding an additive adhesive in film form thereto, curing it under heat, roughening it with an alkaline oxidizing agent and forming conductor layers by plating. All of these processes have had the drawback of being low in productivity, since they have many steps calling for strict control, including not only a prolonged step of roughening with an oxidizing agent, but also preparatory steps such as for mechanical polishing and chemical swelling.

In view of the above problems in connection with a multilayer printed-wiring board of the build-up type consisting of alternate layers of conductor circuitry and insulating materials, one aspect of this invention relates to development of an epoxy resin composition for interlayer insulation on whose surface minute protrusions may be formed simply by thermosetting. In another aspect the invention relates to improvement of the productivity of a multilayer printed-wiring board using the 5 composition of the first aspect.

The present inventors have found that if a phenolic curing agent containing a triazine structure is used for a polyfunctional epoxy resin, and if a rubber component is added thereto, minute protrusions may be formed on its surface simply by thermosetting. Thus, this invention resides in an epoxy resin composition comprising or, preferably, consisting essentially of:
(A) an epoxy resin having two or more epoxy groups in each molecule;
(B) a phenolic resin composition comprising a mixture, or condensation product of phenols, a compound having a triazine ring and aldehydes, the mixture or condensation product being substantially free from any unreacted aldehydes, or methylol group;
(C) a rubber component; and
(D) a curing accelerator.
The composition is such that, when it is subject to thermosetting at a temperature of 80°C or above minute protrusions form on its surface having a maximum height (Ry) ≥ 1.0 µm. In a further aspect a process is provided for manufacturing a multilayer printed-wiring board using the same.

The epoxy resin having two or more epoxy groups in each molecule, which is used as component (A) according to this invention, is necessary for an interlayer insulating material having sufficiently high levels of 5 physical properties, such as heat and chemical resistances, and electrical properties. More specifically, it is possible to use one of known and common resins, or a combination of two or more, such as a bisphenol A type epoxy resin, a bisphenol F type epoxy resin, a bisphenol S type epoxy resin, a phenol novolak type epoxy resin, an alkylphenol novolak type epoxy resin, a biphenol type epoxy resin, a naphthalene type epoxy resin, a dicyclopentadiene type epoxy resin, an epoxidated product of a condensation product of phenols and aromatic aldehydes having phenolic hydroxyl groups, triglycidyl isocyanurate, an alicyclic epoxy resin, and a brominated product of any of the above epoxy resins. It may contain a monofunctional epoxy resin as a reactive diluent.

Those which are disclosed in Japanese Patent Applications Laid-Open Nos. Hei 8-253557 and Hei 8-311142 can be mentioned as examples of the phenolic resin composition used as component (B) according to this invention, which comprises a mixture, or condensation product of phenol molecules, a compound having a triazine ring and aldehyde molecules which is substantially free from any unreacted aldehydes, or methylol group. More specific examples are a series of Phenolite 7050 manufactured by Dainippon Ink & Chemicals Inc, which are novolak resins containing a triazine structure as represented by the model structural formula (1) shown below. As regards the proportion of the phenolic resin composition (B), it is preferable to employ 0.5 to 1.3 phenolic hydroxyl equivalents thereof relative to one epoxy equivalent of the epoxy resin (A). Deviation from this range may result in a cured product of low heat resistance.

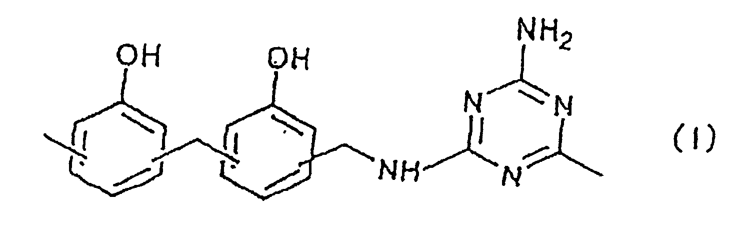

Examples of the rubber component used as component (C) according to this invention are polybutadiene rubbers, modified polybutadiene rubbers such as epoxy-, urethane- or (meth)acrylonitrile-modified ones, and (meth)acrylonitrile-butadiene rubbers containing carboxyl groups. As regards the proportion of the rubber component (C), it is preferable to see that it fall within the range of 5 to 50 parts by weight relative to a total of 100 parts by weight of the epoxy resin (A) and the phenolic resin composition (B). A proportion of less than 5% by weight may result in failure to obtain a satisfactorily uneven surface by thermosetting, and a proportion exceeding 50% by weight may result in an interlayer insulating material which is unacceptable for practical use because of its low heat resistance, poor electrical properties and poor chemical resistance.

Referring to the curing accelerator used as component (D) according to this invention, it is possible to use one of known and commonly used substances, or a combination of two or more, including imidazoles, tertiary amines, guanidines, or epoxy adducts or microcapsulated products thereof, and organic phosphine compounds, such as triphenylphosphine, tetraphenyl phosphonium and tetraphenyl borate. As regards the proportion of the curing accelerator (D), it is preferable to see that it fall within the range of 0.05 to 10 parts by weight relative to a total of 100 parts by weight of the epoxy resin (A) and the phenolic resin composition (B). Its proportion of less than 0.05 part by weight results in insufficient curing, and its proportion exceeding 10 parts by weight is not effective for any further acceleration of curing, but rather results in a product of lower heat resistance and mechanical strength.

The epoxy resin composition of this invention may further contain a binder polymer, a thermosetting resin and known and commonly used additives in addition to its essential components described above. Examples of the binder polymer are a (brominated) phenoxy resin, a polyacrylic resin, a polyimide resin, a polyamideimide resin, a polycyanate resin, a polyester resin and a thermosetting polyphenylene ether resin. Examples of the thermosetting resin are a blocked isocyanate resin, a xylene resin, a radical forming agent and a polymerizable resin. Examples of the additives are an inorganic filler such as barium sulfate, barium titanate, a silicon oxide powder, amorphous silica, talc, clay or a mica powder, an organic filler such as a silicone powder, a nylon powder or a fluorine powder, a thickening agent such as asbestos, orben or bentone, a silicone, fluorine or high molecular defoaming and/or leveling agent and an adhesion improver such as imidazole, thiazole, triazole, or a silane coupling agent. It is also possible to use a known and commonly used coloring agent, such as Phthalocyanine Blue, Phthalocyanine Green, Iodine Green, Disazo Yellow, titanic oxide or carbon black, if required.

The epoxy resin composition of this invention may contain an organic solvent. As the organic solvent, it is possible to use one of ordinary solvents, or a combination of two or more, including ketones such as acetone, methyl ethyl ketone and cyclohexanone, acetic esters such as ethyl acetate, butyl acetate, cellosolve acetate, propylene glycol monomethyl ether acetate and carbitol acetate, cellosolves such as cellosolve and butyl cellosolve, carbitols such as carbitol and butyl carbitol, aromatic hydrocarbons such as toluene and xylene, dimethylformamide and dimethylacetamide.

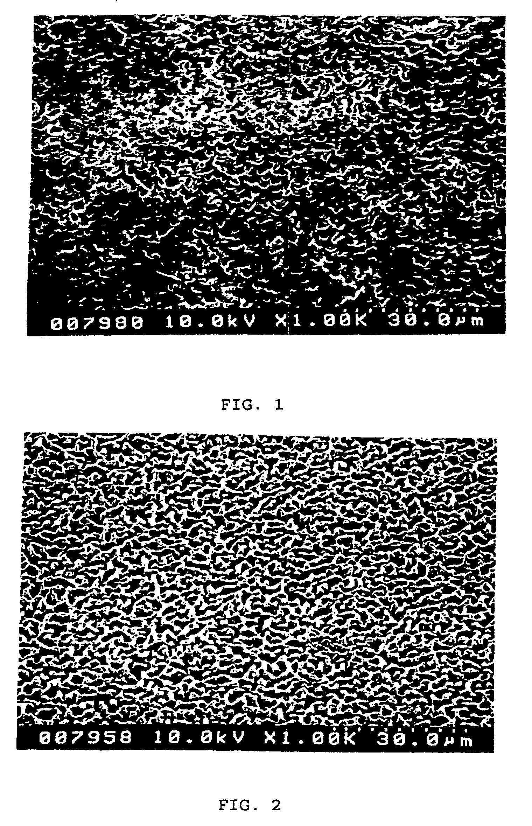

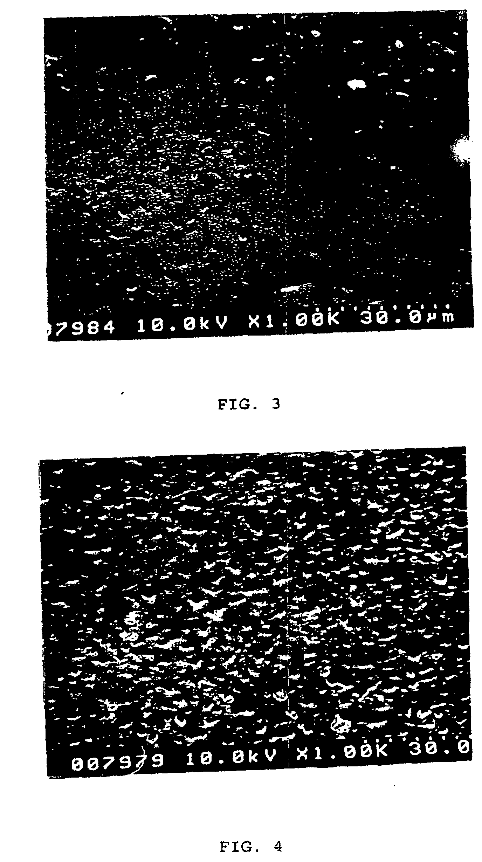

Description will now be made of a process for manufacturing a multilayer printed-wiring board using the epoxy resin composition of this invention. The epoxy resin composition of this invention is first formed on a patterned internal-layer circuit board. The composition in the form of an ink is coated on the board, and thermoset, after drying if it contains an organic solvent. In the case of using an adhesive film formed from the epoxy resin composition of this invention, it is laminated on the board under heat, and thermoset. The internal-layer circuit board may, for example, be an epoxy/glass laminate, a metal board, a polyester board, a polyimide board, a BT resin board, or a thermosetting polyphenylene ether board, and may have a roughened surface. Its thermosetting is carried out by heating at or above 80°C, preferably between 100°C and 180°C for 15 to 90 minutes. The surface of the resin layer as thermoset has minute protrusions having a maximum roughness (Ry) ≥ 1.0 µm (Figures 1 and 2). Although we do not have any detail as to why the protrusions are formed simply by thermosetting, we, the inventors of this invention, have found that no protrusion is formed on the surface of a resin layer even by using a conventional phenolic curing agent, such as phenol or cresol novolak, with a polyfunctional epoxy resin, and adding a rubber component (Figure 3). We assume that the surface of a resin layer rises and forms minute protrusions if a rubber component forming an island structure by phase separation during thermosetting is added to a curing agent having a crosslinking group differing in reactivity from a phenolic hydroxyl group and active hydrogen in triazine. This makes it possible to eliminate any mechanical grinding or chemical swelling treatment for carrying out the subsequent roughening treatment efficiently.

Then, the necessary through or via holes are made by a drill and/or a laser or plasma. Then, roughening treatment is given by an oxidizing agent, such as permanganate, bichromate, ozone, hydrogen peroxide/sulfuric acid, or nitric acid. As the surface of the resin layer already has minute protrusions, its roughening is performed if it is necessary to remove any smear from the holes, but as the rubber component is soluble in the oxidizing agent, protrusions having a still higher anchoring effect can be made by the roughening step. Then, conductor layers are formed by electroless and/or electrolytic plating, and if a plated resist having the reverse pattern from the conductor layers is formed, the conductor layers can be formed simply by electroless plating. After the conductor layers have been formed, annealing is done at 150°C to 180°C for 15 to 60 minutes to cure any residual unreacted epoxy resin and improve the heat resistance of the resin layer and the peel strength of the conductor layers to a further extent.

### [Examples]

Examples, examples of manufacture and comparative examples will now be shown for describing embodiments of this invention more specifically, though they are not intended for limiting the scope of this invention. Embodiments of the invention and comparative examples are described below with with reference to the accompanying figures of which:
[Figure 1] is a traced view of a photograph taken through a SEM of the surface of the resin layer formed by applying the epoxy resin composition of Example 1 onto the internal-layer circuit board by screen printing, drying it at 120°C for 10 minutes, and after its application and drying on the reverse side, too, thermosetting it at 150°C for 30 minutes, as shown in Example 1 of Manufacture;
[Figure 2] is a traced view of a photograph taken through a SEM of the surface of the resin layer formed by laminating the adhesive film of Example 2 on both sides of the internal-layer circuit board by a vacuum laminator at a temperature of 100°C, a pressure of 1 kgf/cm² and an atmospheric pressure of 5 mm Hg or below, removing the PET film and thermosetting the resin composition at 150°C for 30 minutes, as shown in Example 2 of Manufacture;
[Figure 3] is a traced view of a photograph taken through a SEM of the surface of the resin layer formed by applying the epoxy resin composition of Comparative Example 1 onto the internal-layer circuit board by screen printing, drying it at 120°C for 10 minutes, and after its application and drying on the reverse side, too, thermosetting it at 150°C for 30 minutes, as shown in Comparative Example 1 of Manufacture; and
[Figure 4] is a traced view of a photograph taken through a SEM of the surface of the resin layer formed by applying the epoxy resin composition of Comparative Example 2 onto the internal-layer circuit board by screen printing, drying it at 120°C for 10 minutes, and after its application and drying on the reverse side, too, thermosetting it at 150°C for 30 minutes, as shown in Comparative Example 2 of Manufacture.

[Example 1] An epoxy resin composition was prepared by dissolving 30 parts by weight (the proportions being all expressed in parts by weight throughout the following description) of a bisphenol A type epoxy resin (Epon 1001 of Yuka Shell Epoxy K.K. having an epoxy equivalent of 469) and 40 parts of a cresol novolak type epoxy resin (EPICLON N-673 of Dainippon Ink & Chemicals Inc. having an epoxy equivalent of 215) as component (A) and 30 parts of a phenol novolak resin containing a triazine structure (Phenolite KA-7052 of Dainippon Ink & Chemicals Inc. having a phenolic hydroxyl equivalent of 120) as component (B) in 20 parts of ethyl diglycol acetate and 20 parts of solvent naphtha under heating and stirring, and adding 15 parts of end-epoxidated polybutadiene rubber (Denarex R-45EPT of Nagase Chemicals Ltd.) as component (C), 1.5 parts of a crushed product of 2-phenyl-4,5-bis(hydroxymethyl)imidazole as component (D), 2 parts of finely divided silica and 0.5 part of a silicone-based defoaming agent.

[Example 2] An epoxy resin composition was prepared by dissolving 15 parts of a bisphenol A type epoxy resin (Epon 828EL of Yuka Shell Epoxy (K.K.) having an epoxy equivalent of 185), 15 parts of a bisphenol A type epoxy resin (Epon 1001 of Yuka Shell Epoxy K.K.) and 35 parts of a cresol novolak type epoxy resin (EPICLON N-673 of Dainippon Ink & Chemicals Inc.) as component (A) in methyl ethyl ketone (hereinafter referred to as MEK) under heating and stirring, and adding 50 parts of a MEK varnish of a phenol novolak resin containing a triazine structure (Phenolite LA-7052 of Dainippon Ink & Chemicals Inc. containing 60% of nonvolatile matter having a phenolic hydroxyl equivalent of 120) as component (B), 10 parts of intramolecularly epoxidated polybutadiene rubber (Epolead PB-3600 of Daicel Chemical Industries Ltd.) as component (C), one part of tetraphenylphosphonium-tetraphenylborate as component (D), 50 parts of a brominated phenoxy resin varnish (YPB-40-PXM40 of Tohto Kasei Co., Inc. having a nonvolatile content of 40% by weight and a bromine content of 25% by weight and containing a solvent mixture of xylene, methoxypropanol and methyl ethyl ketone having a ratio of 5 : 2 : 8) and 2 parts of finely divided silica. The epoxy resin composition as prepared in varnish form was applied by a roller coater onto a PET film having a thickness of 38 µm to form a layer having a dry thickness of 65 µm, and was dried at 80°C to 120°C for 10 minutes, whereby an adhesive film was obtained.

[Comparative Example 1] An epoxy resin composition was prepared by using 26 parts of a phenol novolak resin (BRG-557 of Showa Highpolymer Co., Ltd. having a phenolic hydroxyl equivalent of 104) instead of the 30 parts of a phenol novolak resin containing a triazine structure and otherwise repeating Example 1.

[Comparative Example 2] An epoxy resin composition was prepared by repeating Example 1, but eliminating the 15 parts of an end-epoxidated polybutadiene rubber (Denarex R-45EPT of Nagase Chemicals Ltd.).

[Example 1 of Manufacture] An internal-layer circuit board was formed from an epoxy-glass laminate clad on both sides with a copper foil having a thickness of 35 µm, and the epoxy resin composition which had been prepared in Example 1 was applied thereon by screen 5 printing, and dried at 120°C for 10 minutes, and after its application and drying on the reverse side, too, it was thermoset at 150°C for 30 minutes. A photograph of the surface of the resulting resin layer as taken through a SEM is shown in Figure 1. Its surface roughness as determined (by SURFCOM470A of Tokyo Seimitsu Co., Ltd.) confirmed the formation of minute protrusions having a maximum height Ry of 2 µm (JIS B0601). Then, the necessary through or via holes were made by a drill and/or a laser, and after quick roughening with an alkaline oxidizing agent, such as permanganate, electroless and/or electrolytic plating was performed to make a four-layer printed-wiring board in accordance with a subtractive process. After 30 minutes of annealing at 170°C, the conductor was examined for its peel strength (JIS C6481) and showed an adhesive property as good as 1.0 kg/cm. The four-layer printed-wiring board was also tested for its heat resistance by 60 seconds of dipping in a solder bath at 260°C and did not show any abnormal change in appearance.

[Example 2 of Manufacture] An internal-layer circuit board was formed from an epoxy-glass laminate clad on both sides with a copper foil having a thickness of 35 µm, and the adhesive film which had been prepared in Example 2 was laminated on both sides of the board by a vacuum laminator at a temperature of 100°C, a pressure of 1 kgf/cm² and an atmospheric pressure of 5 mm Hg or below, whereafter the PET film was removed and the resin composition was thermoset at 150°C for 30 minutes. A photograph of the surface of the resulting resin layer as taken through a SEM is shown in Figure 2. Its surface roughness as determined confirmed the formation of minute protrusions having a maximum height Ry of 4 µm. Then, the necessary through or via holes were made by a drill and/or a laser, and after quick roughening with an alkaline oxidizing agent, such as permanganate, a plated resist having the reverse pattern from the conductor layers was formed to make a four-layer printed-wiring board in accordance with an additive process. After 60 minutes of annealing at 150°C, the conductor was examined for its peel strength and showed an adhesive property as good as 1.2 kg/cm. The four-layer printed-wiring board was also tested for its heat resistance by 60 seconds of dipping in a solder bath at 260°C and did not show any abnormal change in appearance.

[Comparative Example 1 of Manufacture] An internal-layer circuit board was formed from an epoxy-glass laminate clad on both sides with a copper foil having a thickness of 35 µm, and the epoxy resin composition which had been prepared in Comparative Example 1 was applied thereon by screen printing, and dried at 120°C for 10 minutes, and after its application and drying on the reverse side, too, it was thermoset at 150°C for 30 minutes. A photograph of the surface of the resulting resin layer as taken through a SEM is shown in Figure 3. Nothing like minute protrusions was formed. An attempt was made to make a four-layer printed-wiring board by repeating Example 1 of Manufacture, but a blister was found in the conductor layers as plated.

[Comparative Example 1 of Manufacture] An internal-layer circuit board was formed from an epoxy-glass laminate clad on both sides with a copper foil having a thickness of 35 µm, and the epoxy resin composition which had been prepared in Comparative Example 2 was applied thereon by screen printing, and dried at 120°C for 10 minutes, and after its application and drying on the reverse side, too, it was thermoset at 150°C for 30 minutes. A photograph of the surface of the resulting resin layer as taken through a SEM is shown in Figure 4. The measurement of its surface roughness gave an Ry value of 0.8 µm. Example 1 of Manufacture was repeated for making a four-layer printed-wiring board. A blister was, however, found in the conductor layers during 30 minutes of annealing at 170°C.

The results of Examples 1 and 2 and Examples 1 and 2 of Manufacture confirm that the process of this invention enables the manufacture of a highly reliable multilayer printed-wiring board of the build-up type, since it makes it possible to form a copper plating layer of high adhesive strength without any mechanical grinding, or chemical swelling, and make a printed-wiring board of high heat resistance. According to Comparative Example 1 employing a conventional phenol novolak curing agent, and Comparative Example 2 not employing any rubber component, however, no uneven surface having a satisfactory anchoring effect could be formed on the resin layer, but there could only be formed a copper plating layer which was too low in adhesive strength to be practically acceptable.

In conclusion, embodiments of the process of this invention facilitate the manufacture of a highly reliable multilayer printed-wiring board of the build-up type, by making easier the formation of a copper plating layer of high adhesive strength, and of a printed-wiring board of high heat resistance.

## Claims

1. An epoxy resin composition comprising:
(A) an epoxy resin having two or more epoxy groups in each molecule;
(B) a phenolic resin composition comprising a mixture, or condensation product of phenols, a compound having a triazine ring and aldehydes, said mixture or condensation product being substantially free from any unreacted aldehydes, or methylol group;
(C) a rubber component; and
(D) a curing accelerator.

2. A composition, as obtainable by thermosetting a composition of claim 1 at or above 80°C, having protrusions formed on its surface as a result of thermosetting, the protrusions having a maximum height (Ry) ≥ 1.0µm.

3. An epoxy resin composition as set forth in claim 1, comprising 0.5 to 1.3 phenolic hydroxyl equivalents of the phenolic resin composition (B) relative to one epoxy equivalent of the epoxy resin (A), and 5 to 50 parts by weight of the rubber component (C) and 0.05 to 10 parts by weight of the curing accelerator (D) relative to a total of 100 parts by weight of the epoxy resin (A) and the phenolic resin composition (B).

4. A method for the formation of an insulating layer on a circuit board layer comprising applying to the circuit board layer a composition of claim 1 or claim 3 and thermosetting at a temperature of 80°C or above.

5. A process for manufacturing a multilayer printed-wiring board comprising forming an epoxy resin composition as set forth in claim 1 or 3 on a patterned internal-layer circuit board, thermosetting it at or above 80°C, roughening the surface of said composition with an oxidizing agent, if require, and forming conductor layers by plating.

## Patentansprüche

1. Epoxyharzzusammensetzung, welche enthält:
(A) ein Epoxyharz mit zwei oder mehr Epoxygruppen in jedem Molekül;
(B) eine phenolische Harzzusammensetzung, die ein Gemisch oder ein Kondensationsprodukt von Phenolen, einer Verbindung mit einem Triazinring und Aldehyden enthält, wobei das Gemisch oder das Kondensationsprodukt im wesentlichen frei von jeglichen nicht umgesetzten Aldehyden oder Methylolgruppen ist;
(C) eine Kautschukkomponente; und
(D) ein Härtungsbeschleuniger.

2. Zusammensetzung, die durch Hitzehärten einer Zusammensetzung nach Anspruch 1 bei oder über 80°C erhalten werden kann und auf ihrer Oberfläche als Ergebnis des Hitzehärtens Vorsprünge hat, wobei die Vorsprünge eine maximale Höhe (Ry) ≥ 1,0 µm haben.

3. Epoxyharzzusammensetzung nach Anspruch 1, die 0,5 bis 1,3 phenolische Hydroxyäquivalente der phenolischen Harzzusammensetzung (B), bezogen auf ein Epoxyäquivalent des Epoxyharzes (A), und 5 bis 50 Gew.-Teile der Kautschukkomponente (C) und 0,05 bis 10 Gew.-Teile des Härtungsbeschleunigers (D), bezogen auf insgesamt 100 Gew.-Teile des Epoxyharzes (A) und der phenolischen Harzzusammensetzung (B), enthält.

4. Verfahren zur Herstellung einer Isolierschicht auf einer Schaltkreisschicht, welches das Auftragen einer Zusammensetzung nach Anspruch 1 oder 3 auf die Schaltkreisschicht und das Hitzehärten bei einer Temperatur von 80°C oder darüber umfaßt.

5. Verfahren zur Herstellung einer mehrschichtigen Leiterplatte, welches das Bilden einer Epoxyharzzusammensetzung nach Anspruch 1 oder 3 auf einer gemusterten Leiterplatte mit Innenschicht, das Hitzehärten bei oder über 80°C, erforderlichenfalls das Aufrauhen der Oberfläche der Zusammensetzung mit einem Oxidationsmittel und das Bilden von Leiterschichten durch Beschichten umfaßt.

## Revendications

1. Composition de résine époxy comprenant :
(A) une résine époxy ayant, dans chaque molécule, deux groupes époxy ou plus ;
(B) une composition de résine phénolique comprenant un mélange, ou un produit de condensation, de phénols, d'un composé ayant un cycle triazine et d'aldéhydes, ledit mélange ou ledit produit de condensation étant substantiellement exempt de tout aldéhyde n'ayant pas réagi ou de groupe méthylol;
(C) un composant caoutchouc ; et
(D) un accélérateur de durcissement.

2. Composition, pouvant être obtenue par thermodurcissement d'une composition selon la revendication 1 à une température égale ou supérieure à 80°C, ayant sur sa surface des protubérances formées par suite du thermodurcissement, ces protubérances ayant une hauteur maximale (Ry) ≥ 1,0 µm.

3. Composition de résine époxy selon la revendication 1, comprenant 0,5 à 1,3 équivalent de groupes hydroxyle phénoliques provenant de la composition de résine phénolique (B) pour un équivalent époxy provenant de la résine époxy (A) et 5 à 50 parties en masse de composant caoutchouc (C) et 0,05 à 10 parties en masse d'accélérateur de durcissement (D) pour 100 parties en masse du total résine époxy (A) et composition de résine phénolique (B).

4. Méthode pour la formation d'une couche isolante sur une couche de carte de circuit imprimé comprenant l'application, sur la couche de carte de circuit imprimé, d'une composition selon la revendication 1 ou la revendication 3 et le thermodurcissement à une température égale ou supérieure à 80°C.

5. Procédé pour la fabrication d'une carte de câblage imprimé à plusieurs couches comprenant la formation d'une composition de résine époxy selon la revendication 1 ou 3 sur une carte de circuit imprimé de couche interne à motifs, son thermodurcissement à une température égale ou supérieure à 80°C, la rugosification de la surface de ladite composition avec un agent oxydant, si nécessaire, et la formation de couches conductrices par revêtement métallique.
